(19)

Europäisches Patentamt
European Patent Office
Office européen des brevets

(11) **EP 4 510 397 A2**

(12) **EUROPEAN PATENT APPLICATION**

(43) Date of publication:
**19.02.2025 Bulletin 2025/08**

(21) Application number: **24194522.9**

(22) Date of filing: **14.08.2024**

(51) International Patent Classification (IPC):
**H01S 3/0971** (2006.01) **H01S 3/223** (2006.01)
**H01S 3/23** (2006.01) **H01S 3/104** (2006.01)

(52) Cooperative Patent Classification (CPC):
**H01S 3/09702; H01S 3/104;** H01S 3/0971;
H01S 3/2232; H01S 3/2366

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.08.2023 US 202363532778 P
05.04.2024 US 202463575281 P
13.08.2024 US 202418802317**

(60) Divisional application:
**24208431.7**

(71) Applicant: **II-VI Delaware, Inc.
Wilmington, DE 19890 (US)**

(72) Inventors:
• **TEISSIER, Jean
Wilmington, 19890 (US)**
• **MAINEULT, Wilfried
Wilmington, 19890 (US)**

(74) Representative: **Schmidt, Christian
ZSP Patentanwälte PartG mbB
Hansastraße 32
80686 München (DE)**

(54) **ULTRAFAST MODULATION VERTICAL-CAVITY SURFACE-EMITTING LASER (VCSEL)**

(57) Systems and methods are provided for ultra-fast modulation vertical-cavity surface-emitting laser (VCSEL). An example optical device includes an optical source and an electro-absorption modulated laser (EML) based structure on top of the optical source. The electro-absorption modulated laser (EML) based structure includes a grating structure, with the grating structure including a plurality of grating lines, and with the grating structure further including Pockels material disposed within the grating structure.

FIG. 1A

## Description

CLAIM OF PRIORITY

This patent application claims priority to and claims benefit from United States Provisional Patent Application Serial No. 63/532,778, filed on August 15, 2023, and United States Provisional Patent Application Serial No. 63/575,281, filed on April 5, 2024. Each of the above identified applications is hereby incorporated herein by reference in its entirety.

TECHNICAL FIELD

Aspects of the present disclosure relate to optical communication based solutions. More specifically, certain implementations of the present disclosure relate to methods and systems for implementing and utilizing ultra-fast modulation vertical-cavity surface-emitting laser (VCSEL).

BACKGROUND

Limitations and disadvantages of conventional diffraction gratings will become apparent to one of skill in the art, through comparison of such systems with some aspects of the present disclosure as set forth in the remainder of the present application with reference to the drawings.

BRIEF SUMMARY

System and methods are provided for ultra-fast modulation vertical-cavity surface-emitting laser (VCSEL), substantially as shown in and/or described in connection with at least one of the figures, as set forth more completely in the claims.

These and other advantages, aspects and novel features of the present disclosure, as well as details of an illustrated embodiment thereof, will be more fully understood from the following description and drawings.

BRIEF DESCRIPTION OF THE DRAWINGS

Figs. 1A-1B illustrate an example ultra-fast modulation vertical-cavity surface-emitting laser (VCSEL) incorporating Pockels material within interdigitated grating to improve performance, in accordance with the present disclosure.

Fig. 2 illustrates an example vertical-cavity surface-emitting laser (VCSEL).

Fig. 3 illustrates an example photonic-crystal surface-emitting laser (PCSEL).

Fig. 4 illustrates an example high-order distributed feedback polymer (DFB).

Fig. 5A illustrates an example vertical-cavity surface-emitting laser (VCSEL) based electro-absorption modulated laser (EML), in accordance with the present disclosure.

Fig. 5B illustrates an example 3-contacts vertical-cavity surface-emitting laser (VCSEL) based electro-absorption modulated laser (EML), in accordance with the present disclosure.

Fig. 5C illustrates an example 4-contacts vertical-cavity surface-emitting laser (VCSEL) based electro-absorption modulated laser (EML), in accordance with the present disclosure.

Fig. 6 illustrates an example high contrast grating (HCG) structure, in accordance with the present disclosure.

Fig. 7 illustrates use of an example high contrast grating (HCG) structure as reflectivity modulator, in accordance with the present disclosure.

Fig. 8 illustrates use of an example high contrast grating (HCG) structure in wavefront modulation, in accordance with the present disclosure.

Fig. 9 illustrates use of an example vertical-cavity surface-emitting laser (VCSEL) based electro-absorption modulated laser (EML) incorporating high contrast grating (HCG) with Pockels material as intensity modulator, in accordance with the present disclosure.

Fig. 10 illustrates different processes for fabricating a vertical-cavity surface-emitting laser (VCSEL) based electro-absorption modulated laser (EML) incorporating high contrast grating (HCG) with Pockels material, in accordance with the present disclosure.

Fig. 11 illustrates dephasing in an example vertical-cavity surface-emitting laser (VCSEL) based electro-absorption modulated laser (EML) incorporating high contrast grating (HCG) with Pockels material, in accordance with the present disclosure.

Fig. 12 illustrates use of an example vertical-cavity surface-emitting laser (VCSEL) based electro-absorption modulated laser (EML) incorporating high contrast grating (HCG) with Pockels material in wavefront modulation, in accordance with the present disclosure.

Fig. 13 illustrates use of an example vertical-cavity surface-emitting laser (VCSEL) based electro-absorption modulated laser (EML) incorporating high contrast grating (HCG) with Pockels material on top of the contacts in wavefront modulation, in accordance with the present disclosure.

Fig. 14 illustrates handling of incoming external light in an example vertical-cavity surface-emitting laser (VCSEL) based electro-absorption modulated laser (EML) with a high contrast gratings (HCG) structure incorporating Pockels material, in accordance with the present disclosure.

Fig. 15 illustrates use of an example vertical-cavity surface-emitting laser (VCSEL) based electro-absorption modulated laser (EML) incorporating high contrast grating (HCG) with Pockels material in polarization modulation, in accordance with the present disclosure.

Fig. 16 illustrates example variations of a high contrast grating (HCG) structure with Pockels material, in accordance with the present disclosure.

Fig. 17 illustrates a first example implementation of an interdigitated electro-absorption modulated laser (EML) based structure, in accordance with the present disclosure.

Fig. 18 illustrates a second example implementation of an interdigitated electro-absorption modulated laser (EML) based structure, in accordance with the present disclosure.

Fig. 19 illustrates a third example implementation of an interdigitated electro-absorption modulated laser (EML) based structure, in accordance with the present disclosure.

Fig. 20 illustrates fourth and fifth example implementations of an interdigitated electro-absorption modulated laser (EML) based structure, in accordance with the present disclosure.

Fig. 21 illustrates a sixth example implementation of an interdigitated electro-absorption modulated laser (EML) based structure, in accordance with the present disclosure.

Fig. 22 illustrates an example vertical-cavity surface-emitting laser (VCSEL) based electro-absorption modulated laser (EML) incorporating high contrast grating (HCG) with Pockels material and with a dielectric for gates, in accordance with the present disclosure.

Fig. 23 illustrates example vertical-cavity surface-emitting laser (VCSEL) based optical devices with one incorporating an electro-absorption modulated laser (EML) based design.

DETAILED DESCRIPTION

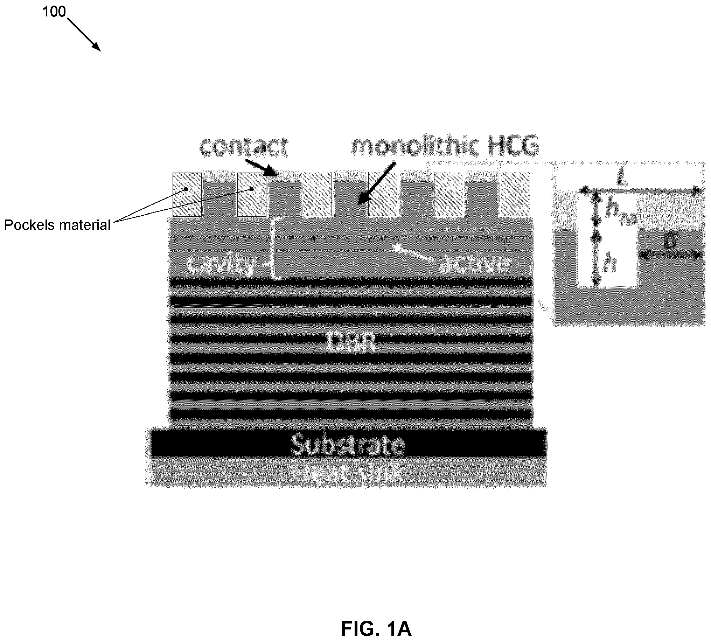

Figs. 1A-1B illustrate an example ultra-fast modulation vertical-cavity surface-emitting laser (VCSEL) incorporating Pockels material within interdigitated grating to improve performance, in accordance with the present disclosure. Referring to Figs. 1A-1B, there is shown a vertical-cavity surface-emitting laser (VCSEL) 100 (or portion thereof) with interdigitated grating, to provide ultra-fast modulation.

In this regard, The VCSEL 100 may comprise a semiconductor laser diode based structure, configured to provide laser beam emission perpendicular from a top surface. For example, the VCSEL may comprise distributed Bragg reflector (DBR) based structures, configured to function as mirrors parallel to the top surface, with an active region comprising one or more quantum wells for the laser light generation in between. One DBR structure may be disposed on top of a substrate layer and heat sink layer. The planar DBR-mirrors may comprise layers with alternating high and low refractive index (RI) based material.

terial.

The thickness of each layer may be set to yield high reflectivity. For example, a thickness of a quarter of the laser wavelength in the material may yield optical reflectivities above 99%. Use of high reflectivity may be used to balance short axial length of the gain region. In some implementations, p-type and n-type regions may be embedded between the DBR-mirrors, forming a diode junction. This may involve more complex semiconductor processing to ensure electrical contact to the active layer/region, but may eliminate electrical power loss in the DBR structure. Fig. 1A illustrates an example structure of the VCSEL 100.

In accordance with the present disclosure, performance of VCSELs may be improved, particularly with respect to the modulation functions and/or characteristics thereof. In particular, this may be done by incorporating adjustments and/or additions to the structure of the VCSELs, which may yield improved performance without adding too much cost and/or complexity.

In this regard, during operation of VCSELs, the drive current may be modulated, which in turn modulates the output laser. However, the modulation of the VCSEL may be limited at times, by different factors including escape time of the photons from the cavity section of the VCSEL. While this lowering the gain may help, doing so still takes some time before photons may escape. This limits the speed of modulation in the VCSEL. Solutions in accordance with the present disclosure allow for modulation faster than photons escape time. This may be done by, e.g., re-directing the beams, to allow overcoming the photons escape time.

For example, in various embodiments based on the present disclosure, an interdigitated grating may be used in the VCSEL, as illustrated in Fig. 1A. In this regard, the interdigitated grating may comprise metallic grating filled with Pockels material-that is, material having high Pockels coefficient material (e.g., Perkinamine™ for organic, KTO, etc.). The Pockels material may be selected based on predetermined selection criteria, such as ensuring that the high contrast grating allows for biasing the laser beams in the manner described herein. The use of interdigitated gratings may allow for creating a "sub-lambda" (or "small with respect to distance to fiber") array of beams that may output the top of the modulator with destructive interference on the far-field, according with the Huygens-Fresnel principle. This leads to high (constructive) or low (destructive) power coupled into the fiber/in the far-field, such as by changing the applied bias between the two interdigitated gratings. As a second part, this effect may be enhanced by resonant effects, embedding this into the cavity.

In some example embodiments, a high contrast grating (HCG) based approach may be used. In this regard, HCGs may be used to replace the top distributed Bragg reflector (DBR) layer of the vertical-cavity surface-emitting laser (VCSEL). In this regard, any suitable high contrast grating (HCG) based design, allowing for achieving the required increase in modulation speed, may be used. In particular, key considerations when selecting and configuring the high contrast grating (HCG) structure used in the VCSEL, to enhance modulation performance thereof, may be the ability to apply bias to the laser beams, applying gate tension, etc. For example, as shown in embodiment illustrated in Fig. 1A, the high contrast grating (HCG) may comprise an etched structure, such as with an "in-plane" periodic or quasi-periodic structure of alternating low and high refractive index (RI), in order to achieve "out-of-plane" high reflectivities. Further, contacts may be disposed on the top of the HCG structure (as shown in Fig. 1A). These contacts may effectively function as a mirror. The contact may comprise metal or any suitable material. In some instances, the HCG structure may incorporate some DBR material above the active layer/region.

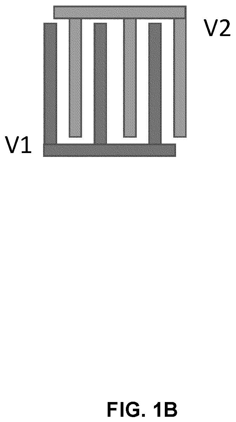

In some example embodiments, a metallic array may be used, such as to connect, respectively, the contacts on the top of the surface of the HCG. This is illustrated in Fig. 1B, which shows a top view of a metallic array as disposed on the top of the VCSEL. The metallic array may be used as interdigitated gates, with the etched high contrast grating (HCG) of the VCSEL being filled (e.g., in DOI: 10.1038/srep40348), with the holes filled with Pockels material. In this regard, the Pockels material need not meet particular filling criteria (e.g., it may be used to fill the holes fully, but that may not be required). Rather, other factors may be relevant, such as the overlapping between the two different paths, and the selection of material used. In this regard, the Pockels coefficient of the material should allow for biasing the laser beams, such as to ensure creating destructive interferences and constructive interferences as described herein. The metal wires of the metallic array (that is, the contacts on top of the HCG) may be connected to one another, and to V2, and may be insulated by a thin insulating layer. Similarly, the Pockels material (paths) filling the holes of the HCG structure may be connected to one another, and to V1. Then, by applying a bias on V2, half of the paths may dephased with respect to the second half, leading to destructive interferences.

Nonetheless, the disclosure is not limited to such design, and solutions based on the present disclosure may be generalized with any suitable shape of grating, any material suitable for use therein, with use (or not) of resonant effect to enhance the Pockels effect, etc.

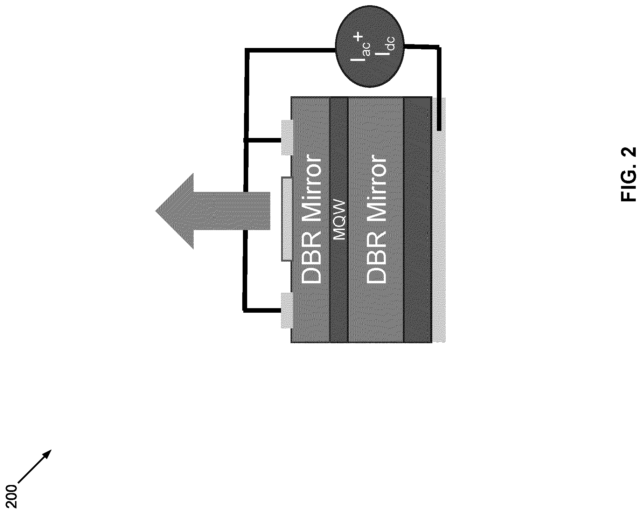

Further, while various aspects and features of the present disclosure are illustrated and described based on VCSEL based implementations, the disclosure is not limited to VCSELs, and similar designs as described herein may be used in other types of optical emitting devices, such as a photonic-crystal surface-emitting laser (PCSEL) and a high-order distributed feedback polymer (DFB). Example VCSEL, PCSEL, and high-order DFB that may be configured to incorporate structural and/or functional modifications based on the present disclosure are illustrated and described with respect to Figs. 2-4.

Fig. 2 illustrates an example vertical-cavity surface-emitting laser (VCSEL). Referring to Fig. 2, there is shown a vertical-cavity surface-emitting laser (VCSEL) 200 (or portion thereof).

VCSELs are commonly used as light (e.g., laser) sources, particularly in such implementations as transceivers (e.g., optical transceivers used in datacenters). Conventionally, VCSELs are driven using one or both of direct current ($I_{dc}$) and alternating current ($I_{ac}$).

As shown in Fig. 2, the VCSEL 200 comprises a multiple-quantum-well (MQW) layer, which functions as a gain medium, sandwiched between two mirrors (e.g., distributed Bragg reflector (DBR) layers). Further, VCSEL 200 comprises contacts, such as on the top side of the top mirror layer, and/or at the bottom side of the VCSEL 200. The contacts may comprise, e.g., metal material or the like.

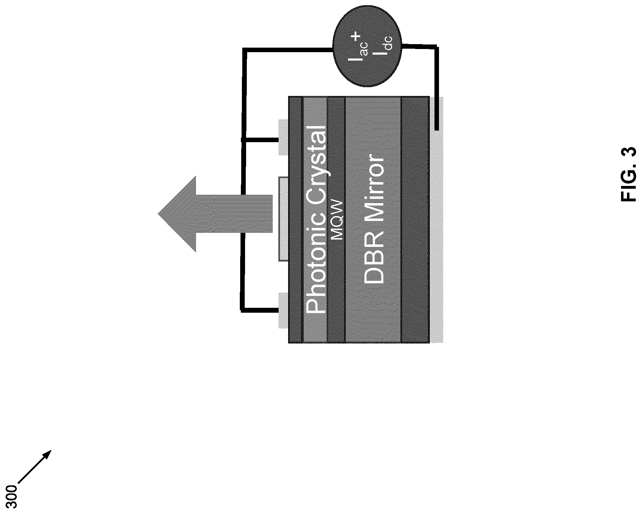

Fig. 3 illustrates an example photonic-crystal surface-emitting laser (PCSEL). Referring to Fig. 3, there is shown a photonic-crystal surface-emitting laser (PCSEL) 300 (or portion thereof).

PCSELs are commonly used as light (e.g., laser) sources, and are conventionally driven using one or both of direct current ($I_{dc}$) and alternating current ($I_{ac}$).

As shown in Fig. 3, the PCSEL 300 comprises a multiple-quantum-well (MQW) layer, which functions as gain medium, sandwiched between a mirror (e.g., distributed Bragg reflector (DBR)) layer on the bottom and a photonic crystal layer on the top of the MQW layer. Further, PCSEL 300 comprises contacts, such as on the top side of the top mirror layer, and/or at the bottom side of the PCSEL 300. The contacts may comprise, e.g., metal material or the like.

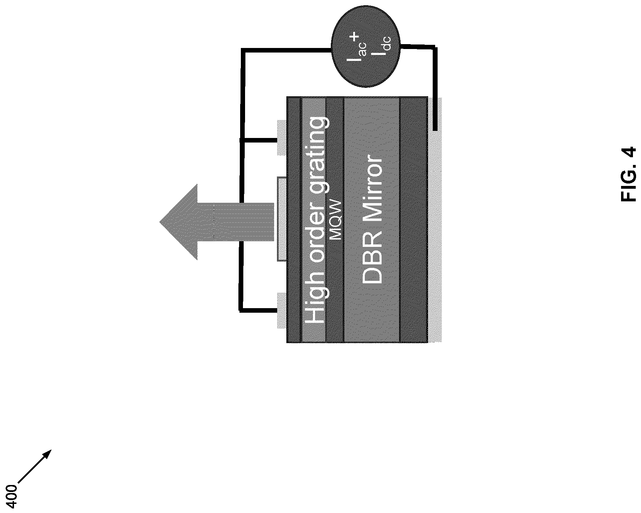

Fig. 4 illustrates an example high-order distributed feedback polymer (DFB). Referring to Fig. 4, there is shown a high-order distributed feedback polymer (DFB) 400 (or portion thereof).

High-order DFBs are commonly used as light (e.g., laser) sources, and are conventionally driven using one or both of direct current ($I_{dc}$) and alternating current ($I_{ac}$).

As shown in Fig. 4, the high-order DFB 400 comprises a multiple-quantum-well (MQW) layer, which functions as gain medium, sandwiched between a mirror (e.g., distributed Bragg reflector (DBR)) layer on the bottom and a high-order grating layer on the top of the MQW layer. Further, the high-order DFB 400 comprises contacts, such as on the top side of the top mirror layer, and/or at the bottom side of the high-order DFB 400. The contacts may comprise, e.g., metal material or the like.

Each of the three different types of optical devices (the VCSEL, PCSEL, and high-order DFB) illustrated in Figs. 2-4 is demonstrated with bottom emission, as solutions based on the present disclosure may also be applied to bottom emissions.

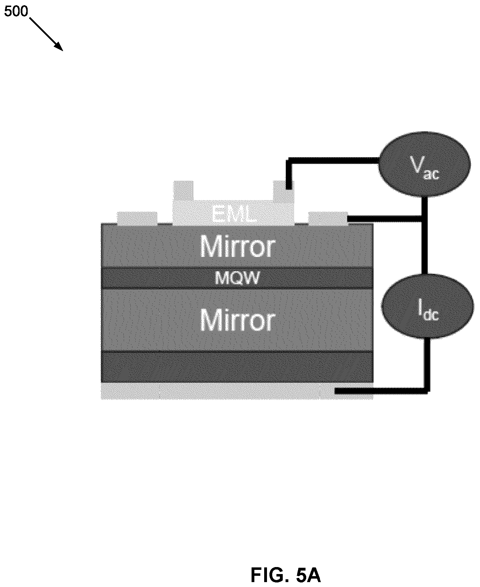

Fig. 5A illustrates an example vertical-cavity surface-emitting laser (VCSEL) based electro-absorption modulated laser (EML), in accordance with the present disclosure. Referring to Fig. 5A, there is shown a vertical-cavity surface-emitting laser (VCSEL) based electro-absorption modulated laser (EML) 500 (or portion thereof).

The VCSEL-EML 500 comprises a multiple-quantum-well (MQW) layer, which functions as gain medium, sandwiched between two mirrors (e.g., distributed Bragg reflector (DBR) layers), with an electro-absorption modulated laser (EML) based structure on top side of the top mirror layer. Further, VCSEL-EML 500 may comprise contacts, such as on the top side of the EML based structure, on the top side of the top mirror layer, and/or at the bottom side of the VCSEL-EML 500. The contacts may comprise, e.g., metal material or the like.

VCSELs are commonly used as light (e.g., laser) sources, particularly in such implementations as transceivers (e.g., optical transceivers used in datacenters). Conventionally, direct-drive or DAC/DC based VCSELs are used. However, such directly modulated VCSELs are getting very close to a bandwidth (BW) bottleneck, between electrical and optical bandwidth.

Accordingly, VCSEL-EML devices are used, where an EML based structure is added, for use in handling at least some of modulation performed in the VCSEL. In this regard, during example operation of a VCSEL-EML, a modulating voltage may be applied across the EML based structure, and a current is then provided to drive the device as a whole. For example, the device may be driven using a time-varying voltage, which allows for digitized based driving (e.g., based on the voltage on or off), such as a digital signal that modulates the output light signal. Alternatively, the device can be driven by direct current (DC) so it is always on. For example, as illustrated in Fig. 5A, in the VCSEL-EML 500 $V_{ac}$ is used drive the EML based structure, whereas $I_{dc}$ is used to drive the device (as whole).

In accordance with the present disclosure, performance of VCSEL-EMLs (e.g., the VCSEL-EML 500) may be improved and/or optimized, particularly by modifying the EML based structure used therein. For example, VCSEL-EMLs may be modified to implement a new modulation scheme, such as by incorporating a vertical EML that uses and/or takes advantage of the Pockels effect. In this regard, in such implementations, the VCSEL may be used as a continuous waveform (CW) light source, with the proposed EML based structure monolithically implemented on top of the VCSEL's top mirror (e.g., DBR) layer. Further, the EML may be modified, to improve performance of the EML and the device as a whole, particularly by incorporating Pockels material to make use of the Pockels effect.

In this regard, the Pockels effect is a directionally-dependent linear variation in the refractive index (RI) of an optical medium that occurs in response to the application of an electric field. The refractive index of an optical medium is a dimensionless number that gives the indication of the light bending ability of that medium. In other words, the refractive index is an indication of speed of light in the material. Accordingly, in various implementations Pockels material is added into the EML based structure to enable (e.g., by controlling applying of voltage across the Pockels material) modulating light based on the material's refractive index (RI), which in turn affects behavior of light beams when applied to the EML based structure.

Such approach may be material agnostic-e.g., utilizing instead adaptation of a bias scheme on top of the EML based structure. In this regard, the Pockels material used in the EML may be selected and/or applied adaptively to ensure that particular performance criteria are met (e.g., as determined in terms of desired or required RI), as described herein. Further, in many instances, the added Pockels material may be used in conjunction with a bias scheme (applicable to the EML based structure), with the bias scheme being adapted for the desired modulation functions.

For example, as illustrated in Fig. 5A, the VCSEL-EML 500 is implemented as an integrated 3-contact VCSEL with laser-DC drive separated from the modulation drive. This allows use of an EML electronic scheme, with a direct-drive of the modulation part. Incorporating Pockels material into the EML based structure allows for improvement in performance based on adaptive use of the Pockels effects. In particular, the Pockels material may be utilized to enable forming and/or utilizing subwavelength patterns to enhance the Pockels effect.

In various example implementations, the EML may incorporate gratings configured to support the modulation functions, with these gratings incorporating Pockels material to make use of the Pockels effect. For example, in some implementations, incorporating Pockels material may be done in conjunction with use of high contrast gratings (HCG). In this regard, use of high contrast gratings (HCG) may be desirable as it may offer various advantages, such as limited optical losses (e.g., << 3dB), ability to use high Pockels material, ability to use readily available simulation capabilities of HCG, etc. In some instances, etching structures in a high index material (e.g., 50-100 nm wide, and 200-400 nm deep) may be utilized.

Depending on configuration, the proposed EML based structure may be used to provide various modulation functions. For example, the EML may be used to modulate the output power (intensity modulation or amplitude modulation), to modulate the deflection of the beam-e.g., output coupling into the fiber (wavefront modulation), and/or to modulate the polarization of the beam (polarization modulation).

In some instances, the proposed EML based structure may be configured to meet particular performance criteria. For example, the EML may have target $V_{\pi}$ << 5V. Meeting such performance criteria may require designing and/or configuring the EML based structure accordingly. For example, ensuring meeting such target $V_\pi$ may require, e.g., optical field enhancement in Pockels material.

In some instances, the proposed EML based structure may be utilized in other applications, such as for providing 100s Gbps components (e.g., passive optical network (PON) elements (on fiber tips, vertical modulator/couplers, etc.), MUX/DEMUX functions, etc.), for beam steering (e.g., as ultra-fast spatial light modulator), and the like.

In some implementations, the proposed EML based structure may be used in conjunction with a photonic-crystal surface-emitting laser (PCSEL) light source (rather than VCSEL). The use of a PCSEL as a light source may be beneficial-e.g., optimizing benefits from HCG design possibilities. In this regard, a PCSEL may be an optimal light source as it is an intrinsically single mode device, may allow for leveraging the full potential of High Q resonance of the HCG, and/or may allow for uniform illumination of HCG (which allows for avoiding detrimental finite size effects of HCG).

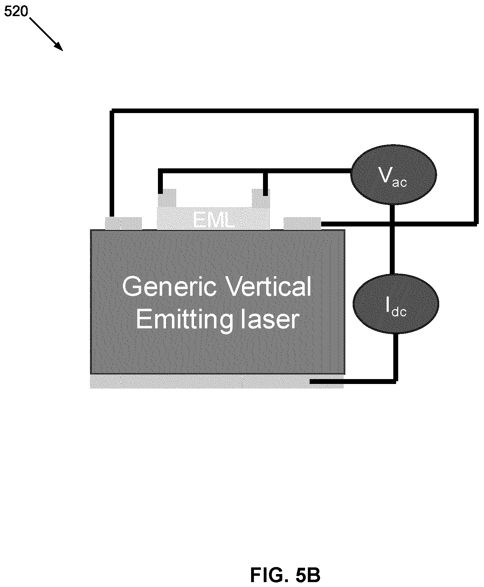

Fig. 5B illustrates an example 3-contacts vertical-cavity surface-emitting laser (VCSEL) based electro-absorption modulated laser (EML), in accordance with the present disclosure. Referring to Fig. 5B, there is shown a vertical-cavity surface-emitting laser (VCSEL) based electro-absorption modulated laser (EML) 520 (or portion thereof).

In this regard, the VCSEL-EML 520 may be substantially similar to the VCSEL-EML 500 of Fig. 5A, and may operate in a substantially manner. In particular, the VCSEL-EML 520 comprises an electro-absorption modulated laser (EML) based structure on top of a generic vertical emitting laser structure. The generic vertical emitting laser structure may comprise any suitable structure that may be configured to enable emitting a laser vertically. For example, the generic vertical emitting laser structure may have a similar structure as the corresponding structure in the VCSEL-EML 500 of Fig. 5A, and as such may comprise a multiple-quantum-well (MQW) layer, which functions as a gain medium, sandwiched between two mirrors (e.g., distributed Bragg reflector (DBR) layers).

Further, VCSEL-EML 520 may comprise contacts, such as on the top side of the EML based structure, on the top side of the generic vertical emitting laser structure, and/or on the bottom side of the generic vertical emitting laser structure. The contacts may comprise, e.g., metal material or the like.

The VCSEL-EML 520 represents an alternative design that utilizes 3 contacts. For example, in the implementation illustrated in Fig. 3B, the 3 contacts may correspond to, respectively, the contact(s) on the top side of the EML based structure, the contact(s) on the top side of the generic vertical emitting laser structure, and the contact(s) on the bottom side of the generic vertical emitting laser structure. These 3 contacts are driven using $I_{dc}$ and/or $V_{ac}$.

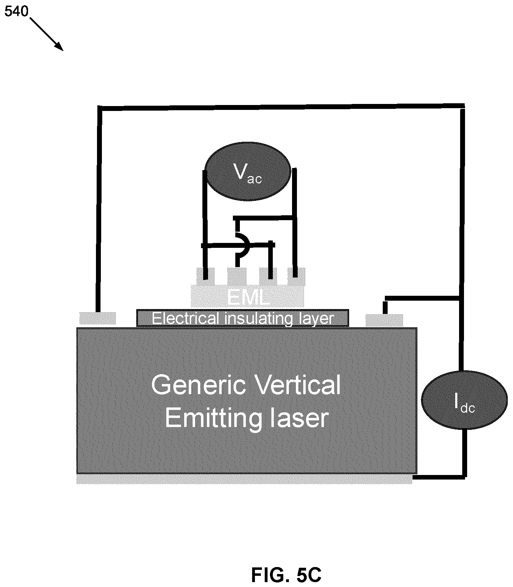

Fig. 5C illustrates an example 4 contacts vertical-cavity surface-emitting laser (VCSEL) based electro-absorption modulated laser (EML), in accordance with the present disclosure. Referring to Fig. 5B, there is shown a vertical-cavity surface-emitting laser (VCSEL) based electro-absorption modulated laser (EML) 540 (or portion thereof).

In this regard, the VCSEL-EML 540 may be substantially similar to the VCSEL-EML 500 of Fig. 5A, and may operate in a substantially manner. In particular, The VCSEL-EML 540 comprises an electro-absorption modulated laser (EML) based structure on top of a generic vertical emitting laser structure, with an electrical insulating layer in-between. The generic vertical emitting laser structure may comprise any suitable structure that may be configured in emitting laser vertically. For example, the generic vertical emitting laser structure may have a similar structure as the corresponding structure in the VCSEL-EML 500 of Fig. 5A, and as such may comprise a multiple-quantum-well (MQW) layer, which functions as gain medium, sandwiched between two mirrors (e.g., distributed Bragg reflector (DBR) layers).

Further, VCSEL-EML 540 may comprise contacts, such as top side of the EML based structure, on the top side of the generic vertical emitting laser structure, and/or on the bottom side of the generic vertical emitting laser structure. The contacts may comprise, e.g., metal material or the like.

The VCSEL-EML 540 represents an alternative design that utilizes 4 contacts. For example, in the implementation illustrated in Fig. 5C, the 4 contacts may correspond to, respectively, the contact(s) on the top side of the EML based structure, the contact(s) on the top side of the generic vertical emitting laser structure, and the contact(s) on the bottom side of the generic vertical emitting laser structure, with the contacts on top of the EML based structure being configured into two separate groups of contacts, as shown in Fig. 5C. These 4 contacts are driven using $I_{dc}$ and/or $V_{ac}$.

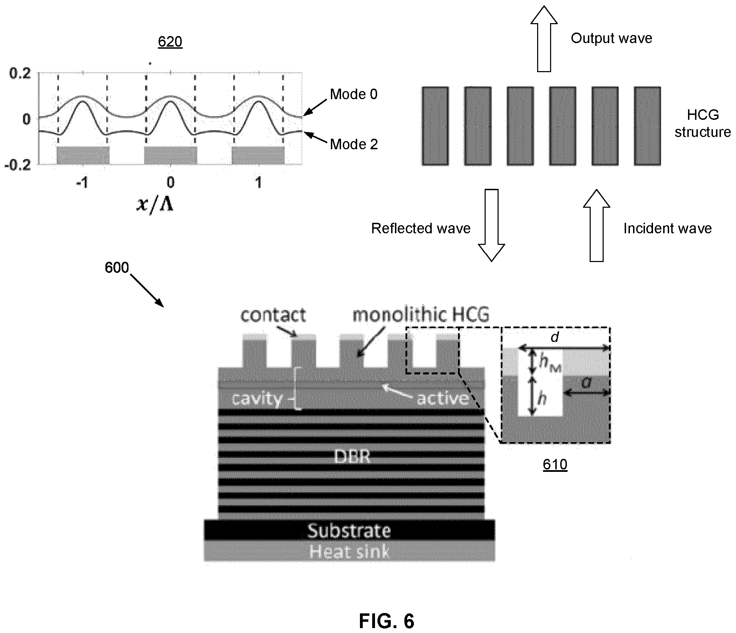

Fig. 6 illustrates an example high contrast grating (HCG) structure, in accordance with the present disclosure. Referring to Fig. 6, there is shown vertical-cavity surface-emitting laser (VCSEL) 600 incorporating a high contrast grating (HCG) 610.

The VCSEL 600 comprises two mirrors with an active layer (e.g., MQW) sandwiched in-between, with the top mirror incorporating the HCG 610. The bottom mirror and the top mirror, with the grating structure, form, in combination with the active layer form, a laser resonator.

As noted above, in some instances a high contrast grating (e.g., the HCG 610) may be utilized in a vertical-cavity surface-emitting laser (VCSEL) based electro-absorption modulated laser (EML) implemented based on the present disclosure, with the HCG being specifically used in the proposed EML based structure for facilitating and/or supporting the modulation functions performed thereby. In this regard, gratings incorporate grating features with gaps therebetween, and may be characterized by such parameters as height of the grating features (dimension h), width of the grating features (dimension a), thickness of contact on top of the grating features (dimension $h_M$), period of the grating features-that is, distance between identical points in successive grating features (dimension d), and total depth of the gaps (combination of dimension h and $h_M$, when contacts are disposed on top of grating features, as shown in Fig. 6).

High contrast gratings, such as the HCG 610, may incorporate grating features with subwavelength dimensions, and may have strong index contrast (e.g., in air index of grating > 1.7). The high contrast may be provided by the gaps, which may be filed (e.g., with air, which has very low RI), resulting in high contrast between the gaps and the grating structure features. In this regard, the grating features are tall (and thus the gaps are deep). In other words, the gaps may be typically deeper than wide to observe specular effects.

High contrast gratings, such as the HCG 610, may exhibit two modes: reflection (mode 0) and transmission (mode 2), with an incident wave (from within the device-that is applied to the HCG from below, after propagating through the underlying substrate) being reflected in mode 0, and passing (as output wave) in mode 2, as shown in Fig. 6 (in graph 620). In this regard, the reflection/transmission modes may be coupled to each other and plane waves. The transmission mode (mode 2) may be determined by destructive interference between the grating features. For example, in coupling made 50/50 (e.g., geometry of HCG), destructive interference may be determined by $\Delta\beta/\lambda = \pi$.

In various instances, high contrast gratings may have two essential features: 1) that only few modes may be excited and out-coupled as "plane wave" from the outside, and 2) that modes may get squeezed in space, getting higher transverse momentum. With respect to feature 1, HCG cuts high spatial frequency components. As such, 2 or 3 modes description of HCG is enough to predict general behavior, with another mode being usually evanescent. In this regard, such other mode(s) may lay below the cone of light, and may enter $2^{nd}$ order when estimating the reflection/transmission properties at HCG interface with air. With respect to feature 2, propagation constant is reduced, and destructive interference between the modes may be obtained (e.g., for structure at < -wavelength).

The high contrast gratings may exhibit different performance characteristics at different wavelength ranges. For example, for subwavelength dimensions, only one mode may exist in the structure, and with increasing HCG thickness, Fabry-Perot (FP) nodes/antinodes may be seen. For the super-wavelength dimensions many modes may exist, with periodic recovery of the input signal in manner/pattern similar to the Talbot effect. In between these two ranges, few modes may exist. Further, at specific locations the two modes may simultaneously resonant in the HCG. For example, with $2n\pi$ phase difference energy may be trapped inside the HCG, and there may be large field enhancement (e.g., 1e3), and may manifest as anti-crossing. With $(2n+1)\pi$ phase difference, part of the energy may be reflected back from HCG.

In addition to its use in providing optical resonating in devices such as VCSELs, High contrast gratings may also be used in other applications, such as beam manipulation (e.g., lens, polarization, diffractive elements), wave guiding (e.g., MMI, spot size converter, etc.), high broadband reflectivity, broadband AR coating, non-linear optics, bio or chemical sensing, etc.

In implementations based on the present disclosure, Pockels material may be incorporated into the HCG structure-e.g., by using Pockels material to fill at least some of the gaps between the grating features and/or to form the grating features (e.g., with the contacts on top). In this regard, use of Pockels material may allow for improving operation of the HCG structure, particularly with respect to modulation functions thereof. This is described in more detail below.

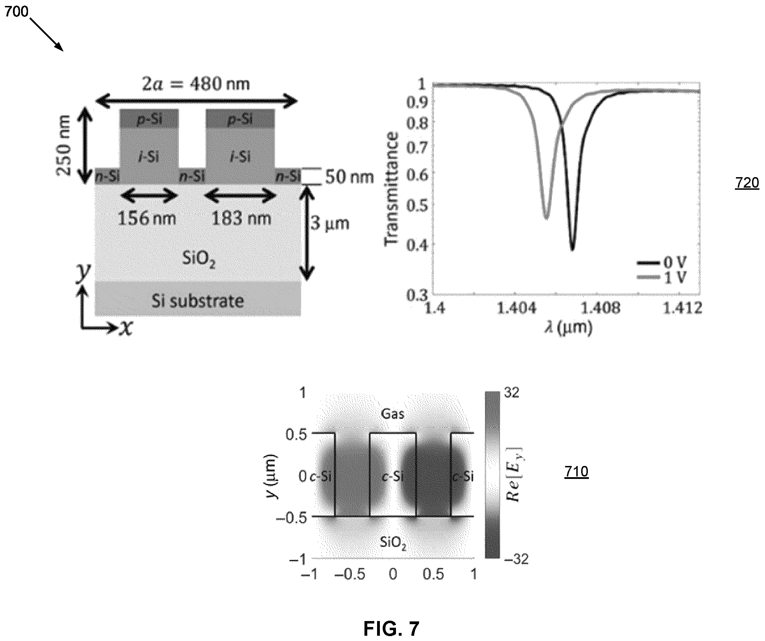

Fig. 7 illustrates use of an example high contrast grating (HCG) structure as reflectivity modulator, in accordance with the present disclosure. Referring to Fig. 7, there is shown a vertical-cavity surface-emitting laser (VCSEL) 700 incorporating a high contrast grating (HCG).

The VCSEL 700 may correspond to a vertical-cavity surface-emitting laser (VCSEL) based electro-absorption modulated laser (EML) implemented based on the present disclosure, with the HCG being used in the proposed EML based structure for facilitating and/or supporting the modulation functions performed thereby. Illustrated in Fig. 7 is an application of HCG-namely, use of HCG in an EML based structure operating as a reflectivity modulator.

Such reflectivity modulator may exhibit high field enhancement. For example, with grating that uses silicon, there may be 30x field enhancement at 2V $"V_\pi"$. Further, in some instances, various aspects or features may be modified to further enhance performance. For example, in some instances, dimerized-HCG may be used (rather than regular HCG) for better control. Also, different material may be used in the grating structure, such as by using BaTiO3 or organic material instead of silicon, which may yield higher tunability.

In example operation of such reflectivity modulator, for beams propagating through the HCG (grating), if the beam has the right wavelength (and/or if the gratings are designed correctly), there will be huge enhancement in the optical field. The electric field of the incident beam between the gratings is greater compared to the electric field of the incident beam before passing through the grating. Similarly, for a beam with the correct wavelength, the structure becomes reflective. The resonance frequency (where the beam gets reflected rather than pass modulated) may be controlled by adjusting the voltage applied to the gratings. This is illustrated in the example use scenario 710 in the VCSEL 700, and captured in graph 720 showing transmittance as a function of wavelength.

In implementations based on the present disclosure, reflectivity modulation may be further enhanced by incorporating Pockels material into the HCG structure-e.g., within the gaps between the features (etchings), by using the Pockels material to form the features (with the contacts on top), etc.

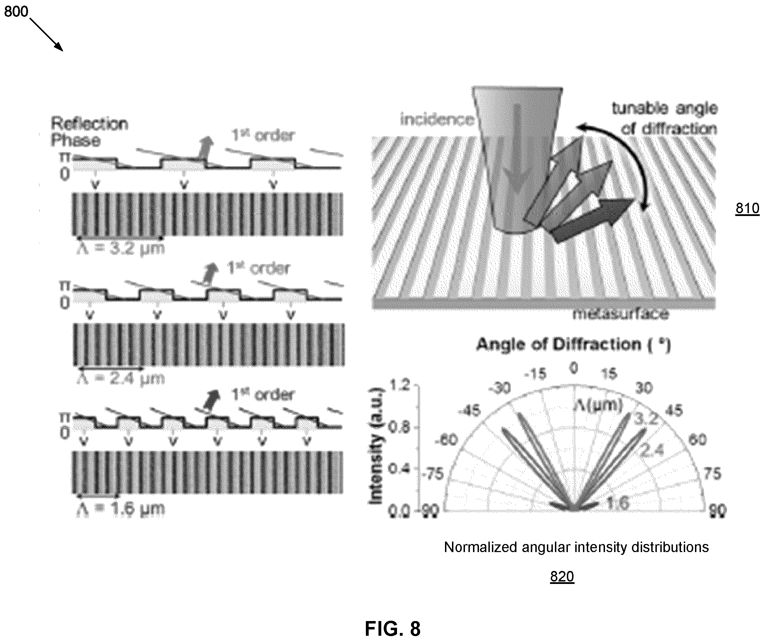

Fig. 8 illustrates use of an example high contrast grating (HCG) structure in wavefront modulation, in accordance with the present disclosure. Referring to Fig. 8, there is shown a high contrast grating (HCG) 800.

The HCG 800 may be used with a vertical-cavity surface-emitting laser (VCSEL) based electro-absorption modulated laser (EML) implemented based on the present disclosure, with the HCG being used in the proposed EML based structure for facilitating and/or supporting the modulation functions performed thereby. Illustrated in Fig. 8 is an application of HCG-namely, use of HCG 800 in an EML based structure operating as a wavefront modulator.

In this regard, in example operation of such wavefront modulator, the HCG may be biased by group-that is, sets of gratings in the HCG structure, as illustrated in Fig. 8. Such biasing allows for deflecting the beam to discrete angle(s). The angle(s) may be defined by, e.g., the discrete geometry of the HCG structure. In some instances, the angle(s) of deflection (or diffraction for external incident beams) may be tunable, as illustrated in Fig. 8 (810) and captured in graph 820 showing normalized angular intensity distribution based on use of an example proposed EML based structure.

In implementations based on the present disclosure, wavefront modulation may be further enhanced by incorporating Pockels material into the HCG structure-e.g., within the gaps between the features (etchings), by using the Pockels material to form the features (with the contacts on top), etc.

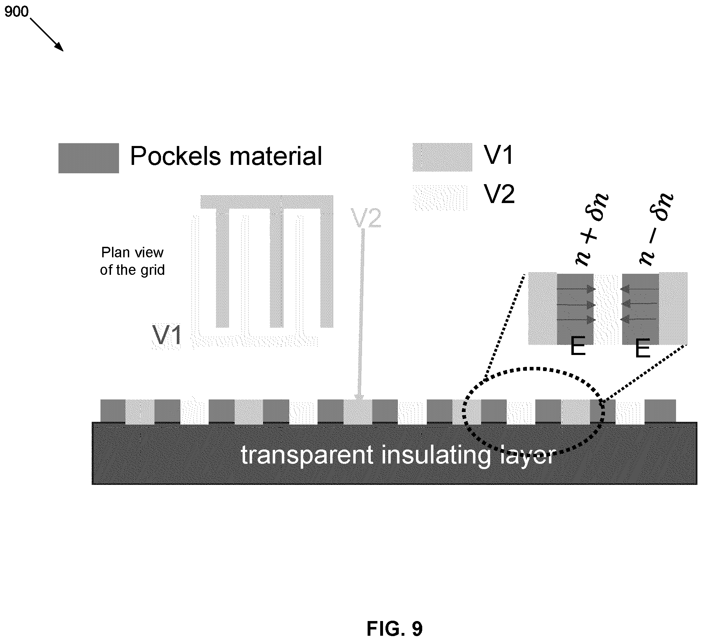

Fig. 9 illustrates use of an example vertical-cavity surface-emitting laser (VCSEL) based electro-absorption modulated laser (EML) incorporating high contrast grating (HCG) with Pockels material as an intensity modulator, in accordance with the present disclosure. Referring to Fig. 9, there is shown a high contrast grating (HCG) 900.

As noted above, in some instances a high contrast grating may be utilized in a vertical-cavity surface-emitting laser (VCSEL) based electro-absorption modulated laser (EML) implemented based on the present disclosure, with the HCG 900 being configured for such use in the proposed EML based structure for facilitating and/or supporting the modulation functions performed thereby.

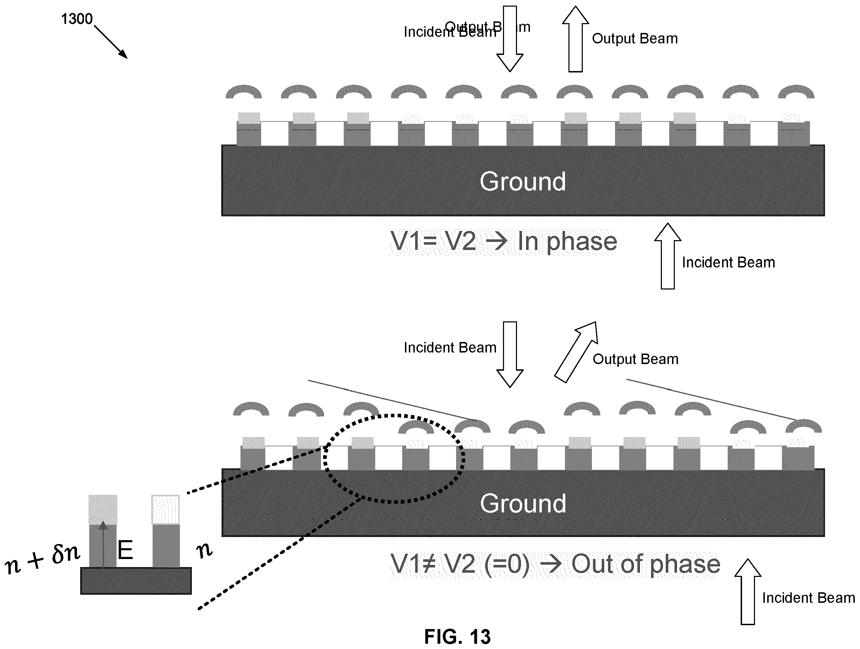

As illustrated in Fig. 9, the HCG 900 may incorporate two contacts, which may be arranged in an interleaved manner (as shown in the plan view-that is, looking down onto the top of structure) thus forming an interdigitated grid of gates. The HCG 900 may also comprise Pockels material. In this regard, in the embodiment illustrated in Fig. 9, the Pockels material is used to fill the gaps between the two contacts. The disclosure is not limited to such approach, however, and as such the arrangement of contacts and/or disposition of Pockels material may be done in any suitable manner. For example, an alternative design is illustrated in Fig. 13, with the contacts laid on top of the Pockels material.

Separate voltages (V1 and V2) may be applied to the two contacts to create particular bias in the HCG. In this regard, the interdigitated grid allows for creating electric fields through the Pockels material between the two different grating elements (corresponding to where V1 and V2 are applied to the contacts). The two contacts are not (necessarily) made of different material; rather, applying different voltages to the contacts creates the different electric fields.

The Interdigitated bias grid creates transverse electric field(s), as shown in Fig. 9-that is, due to the interleaved arrangement, the direction of the electric field across the Pockels material may alternate (as shown). The interdigitated bias grid may also periodically modify the refractive index (RI) of the HCG structure as a whole. In this regard, the RI may be modified in the grating by changing the electric field(s) applied across the Pockels material. Because the RI governs speed of light, modifying the RI alters the phase of the light passing through the grating.

The use of Pockels material may further enhance performance. For example, Pockels material (and Pockels effect corresponding thereto) may be used in conjunction with resonance enhancement (from the grating features) to maintain low $V_{\pi}$. In this regard, the Pockels effect by itself may be too small to achieve a desired $\pi$ phase change, and as such resonance may be also used to achieve required optical field enhancement. As such, achieving the desired Pockels effect may be achieved by providing resonance field enhancement rather than by increasing voltage. In other words, the resonance from the grating structure may be used to increase the strength of the optical field, and thereby enhance the Pockels effect (without increasing the voltage applied to the grating).

As noted, the use of HCG in the proposed EML based structures may allow for achieving low target $V_{\pi}$ (e.g., << 5V). In this regard, without cavity or resonance effect the angle of the tilt (θ) may be determined using the formula:

$$sin(\Theta) \cong \frac{n^2 \Delta V r_{33} h}{d^2}$$

where h is the height of the material, and d the grating period. Without field enhancement, the effect may be too small.



For example, for n=2, $\Delta V$=5V, $r_{33}$=700 pm/V, h=1 um, and d=100 nm, $sin(\Theta)$ =1.4e-2. To enhance by ~10-100, other measures may be needed, such as a vertical DBR cavity, Plasmonic resonance from the grating, and High Contrast gratings (HCG). In this regard, HCGs may provide local $\times 10^3$ field enhancement. Compared to an optical microcavity, the electric field (E) used in the HCG is similar, but with the applied bias being much lower (as the distance between the electrodes is very small). Nonetheless, in some instances HCG may be combined with a DBR cavity for even higher non-linear effects.

As illustrated in Fig. 6, an EML based structure (e.g., used in VCSEL-EML devices) incorporating the HCG 900 may function as an intensity (amplitude) modulator. However, the EML based structure may also be used to provide other functions, such as wavefront modulation, reflectivity modulation, etc.

In some implementations, EML based structures (e.g., used in VCSEL-EML devices) with an HCG incorporating Pockels material may be utilized in providing polarization rotation. In this regard, the grating features are inherently linear polarizers, and thus will selectively transmit optical beams having polarizations in a particular direction (e.g., x-direction). The structure may be configured to provide polarization rotation, which may be used in, e.g., blocking beams. Use of polarization rotation in this manner may be in conjunction with or alternative to use of refractive index related features.

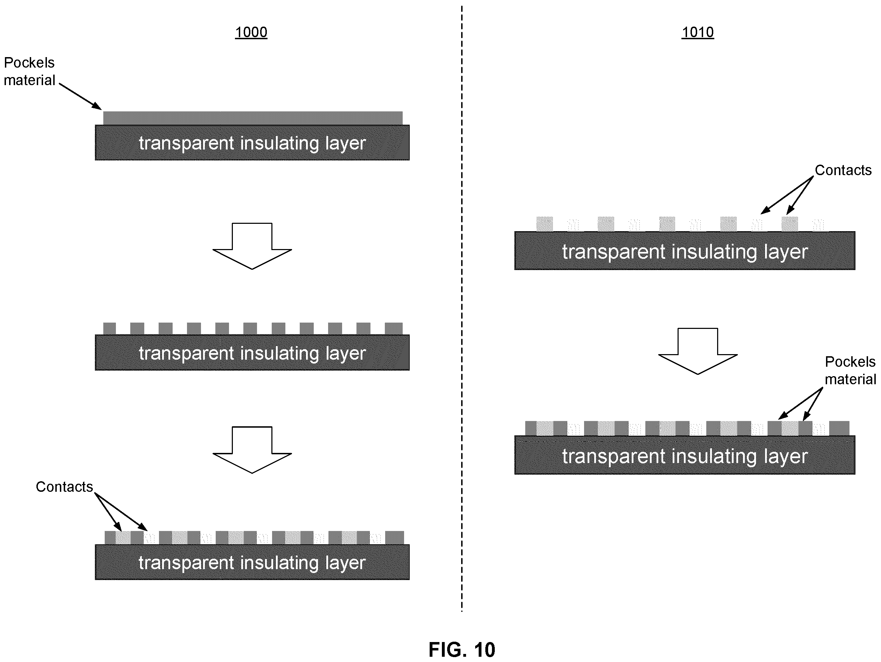

Fig. 10 illustrates different processes for fabricating a vertical-cavity surface-emitting laser (VCSEL) based electro-absorption modulated laser (EML) incorporating high contrast grating (HCG) with Pockels material, in accordance with the present disclosure. Referring to Fig. 10, there are shown two different fabrication processes 1000 and 1010 for fabricating a VCSEL-EML having high contrast grating (HCG) structure with Pockels material.

In this regard, different methods (processes) may be used in fabricating optical devices (e.g., VCSEL) with EML based structures incorporating HCG with Pockels material, and the disclosure is not limited to a particular method or approach. The fabrication methods may differ with respect to the deposition technique used in applying the Pockels material. The fabrication methods also may be affected by the design of the HCG (e.g., with respect to the arrangement of the contacts used therein). For example, when using interdigitated contacts, there may be several physical implementations that may be used, as described in more detail below, and the fabrication methods may need to be adapted to account for use of such arrangement. As such, the fabrication methods may differ in the manner in which the Pockels material is applied in the particular grating (HCG) structure used.

For example, the processes may be "Top bottom" or "Bottom up" depending on the deposition technique of Pockels material, as illustrated in Fig. 10. In this regard, in process 1000, a Pockels material layer is laid first on the insulating layer. The Pockels material layer is then etched to create space for the contacts, which are then added. In process 1010, the contacts are applied first on the insulating layer, with spaces therebetween based on pre-determined interleaved arrangement that comprises spaces between the contacts. The Pockels material layer is then deposited or formed into the spaces between the contacts.

In some instances, the processes used in fabricating the VCSEL-EML may be configured to meet predetermined criteria (e.g., dimensions in the final structure, such as ~250 nm deep, openings in the 50-100 nm range, etc. Thus, fabricating the HCG structure involves addition and/or deposit of ~250 nm on the top to make the HCG, either only in particular areas (the spaces in the bottom up process), or on the whole surface with portion of the applied layer then removed (e.g., via the etching stop).

Implementing the Pockels material-that is, applying it in the grating structure-may be done in various ways, and the disclosure is not limited to any particular approach, and as such any suitable approach may be utilized. For example, the Pocket material may be implemented at wafer bonding level with processing (e.g., using BTO, Li.Nb., BaTiO3, etc.). The Pockels material may be implemented at the end the process, or toward the end (e.g., using organic, BTO based suspension, etc.).

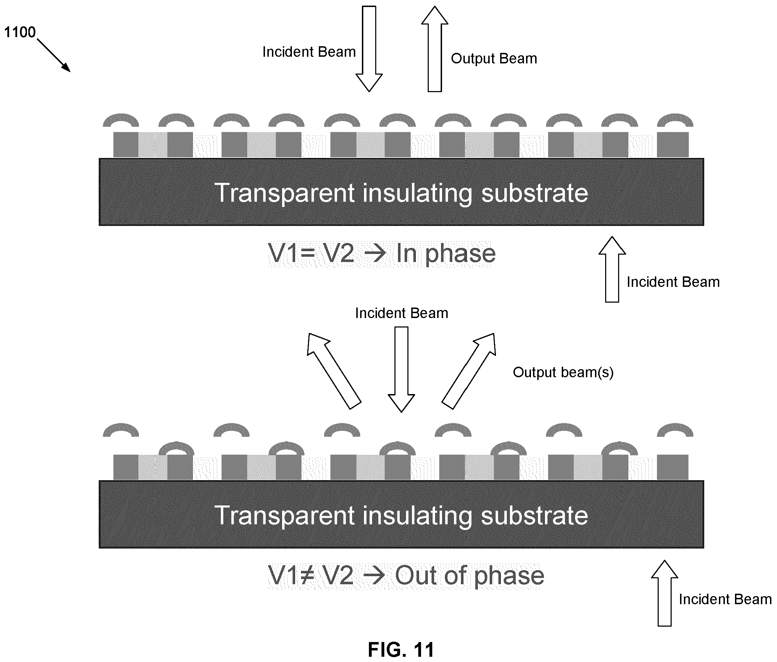

Fig. 11 illustrates dephasing in an example vertical-cavity surface-emitting laser (VCSEL) based electro-absorption modulated laser (EML) incorporating a high contrast grating (HCG) with Pockels material, in accordance with the present disclosure. Referring to Fig. 11, there is shown VCSEL-EML 1100 incorporating an HCG structure with Pockels material within gaps between the contacts. The VCSEL-EML 1100 may be substantially similar to the VCSEL-EML 900 as described with respect to Fig. 9.

Illustrated in Fig. 11 is dephasing in VCSELs such as the VCSEL-EML 1100. In this regard, dephasing may occur as a result of a voltage difference between the interdigitated gates, which may create a periodic change of refractive index (RI) in the structure. For example, the RI may be modified by controlling (setting and/or changing) the electric field applied across the Pockels material. Because the RI governs speed of light, modifying the RI alters the phase of the light passing through the grating.

In VCSELs incorporating two contacts (e.g., the VCSEL-EML 1100), dephasing may be done by adjusting the voltages applied to the two contacts. In this regard, when the voltages are the same in the two contacts (that is, where V1=V2), the contacts would be in-phase, and as such interferences would be constructive vertically, whereas when the voltages are not the same (that is, V1≠V2), a periodic change of refractive index may be created, resulting in destructive interferences vertically and thus dephasing of the contacts (gates).

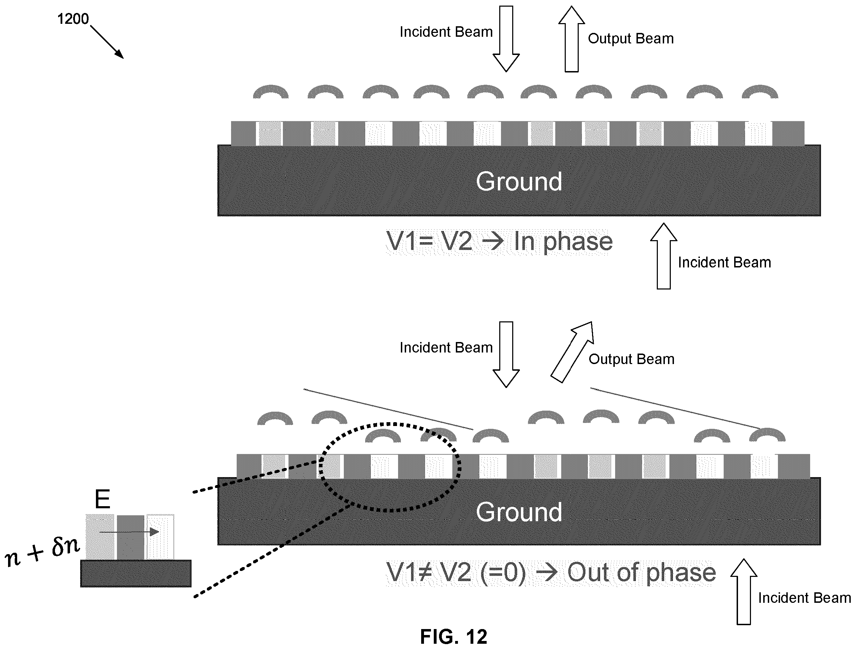

Fig. 12 illustrates use of an example vertical-cavity surface-emitting laser (VCSEL) based electro-absorption modulated laser (EML) incorporating a high contrast grating (HCG) with Pockels material in wavefront modulation, in accordance with the present disclosure. Referring to Fig. 12, there is shown VCSEL-EML 1200 incorporating an HCG structure with Pockels material within gaps between the contacts.

The VCSEL-EML 1200 may be substantially similar to the VCSEL-EML 900 as described with respect to Fig. 9. As illustrated in Fig. 12, the VCSEL-EML 1200 may function as a wavefront modulator. In this regard, the refractive index (RI) may be modified based on changing the electric field applied across the Pockels material onto the different contacts. As noted, RI governs speed of light, and thus modifying the RI alters the phase of the light passing through the grating. Accordingly, the contacts are in phase when the Pockels material is subjected to the same voltage, and are out of phase when the voltages are different, as shown in Fig. 12.

In various implementations, several sub-wavelength gratings may share the same bias. This allows the output wave to stay in the light cone, while creating a dephasing between groups or grating. However, using a Pockels-based EML (e.g., such as the VCSEL-EML 1200 of Fig. 12) as a wavefront modulator may be restricted to only certain types of Pockels material. For example, only Pockels material with strong r42 may be used.

Fig. 13 illustrates use of an example vertical-cavity surface-emitting laser (VCSEL) based electro-absorption modulated laser (EML) incorporating a high contrast grating (HCG) with contacts on top of the Pockels material in wavefront modulation, in accordance with the present disclosure. Referring to Fig. 13, there is shown VCSEL-EML 1300 incorporating an HCG structure with Pockels material.

The VCSEL-EML 1300 may be substantially similar to the VCSEL-EML described with respect to Fig. 9. However, the VCSEL-EML 1300 may differ in that the contacts are disposed on top of the Pockels material, as shown in Fig. 13. As illustrated in Fig. 13, the VCSEL-EML 1300 may function as wavefront modulator. In this regard, the VCSEL-EML 1300, when used as wavefront modulator, may operate in substantially similar manner as the VCSEL-EML 1200, as described with respect to Fig. 12. In particular, the refractive index (RI) may be also modified in the VCSEL-EML 1300 based on changing the electric field applied across the Pockels material-however, the electric field is applied here from the substrate through the Pockels material onto the contacts on top of the Pockels material. As noted, modifying the RI alters the phase of the light passing through the grating, with the contacts being in phase when subjected to the same voltage, and out of phase when the voltages are different, as shown in Fig. 13.

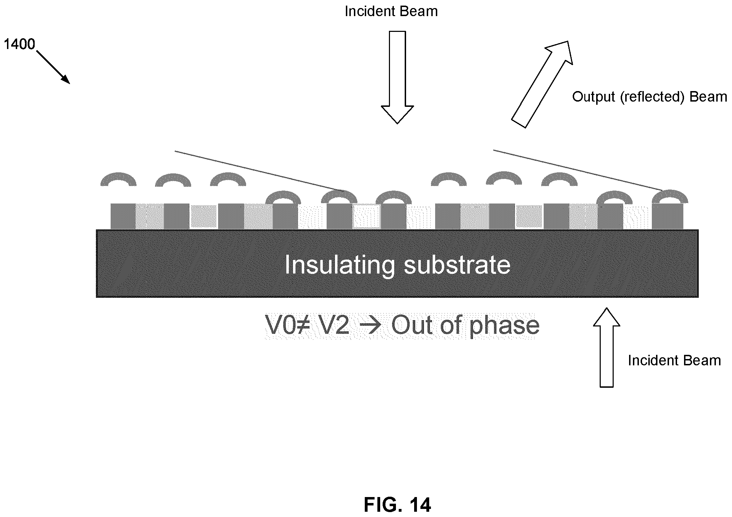

Fig. 14 illustrates handling of incoming external light in an example vertical-cavity surface-emitting laser (VCSEL) based electro-absorption modulated laser (EML) with a high contrast gratings (HCG) structure incorporating Pockels material, in accordance with the present disclosure. Referring to Fig. 14, there is shown VCSEL-EML 1400 incorporating an HCG structure with Pockels material within gaps between the contacts.

The VCSEL-EML 1400 may be substantially similar to the VCSEL-EML 900 as described with respect to Fig. 9. However, the high contrast gratings (HCG) structure in the VCSEL-EML 1400 may comprise different material, such as Aluminum Gallium Arsenide (AlGaAs). Such design (approach) may have various benefits, such as being small, being superfast, having low losses, allowing for wavelength tuning by the grating rather than the material (e.g., Coarse Wavelength Division Multiplexing (CWDM) or Dense Wavelength Division Multiplexing (DWDM) on the same array). Use of an external laser source (e.g., comb-laser) may allow for high temperature/low consumption power data transmission.

Illustrated in Fig. 14 is handling of an incoming beam (light) projected onto the VCSEL-EML 1400 from the outside (rather than from the bottom, through the substrate). In this regard, due to the dephasing, the absorption resonance of the HCG in the VCSEL-EML 1400 may be tweaked, leading to a change of reflectivity. As such, when the voltages applied to the contacts are different, the contact would be out of phase, resulting in the incoming light be reflected back at a particular angle, as shown in Fig. 14.

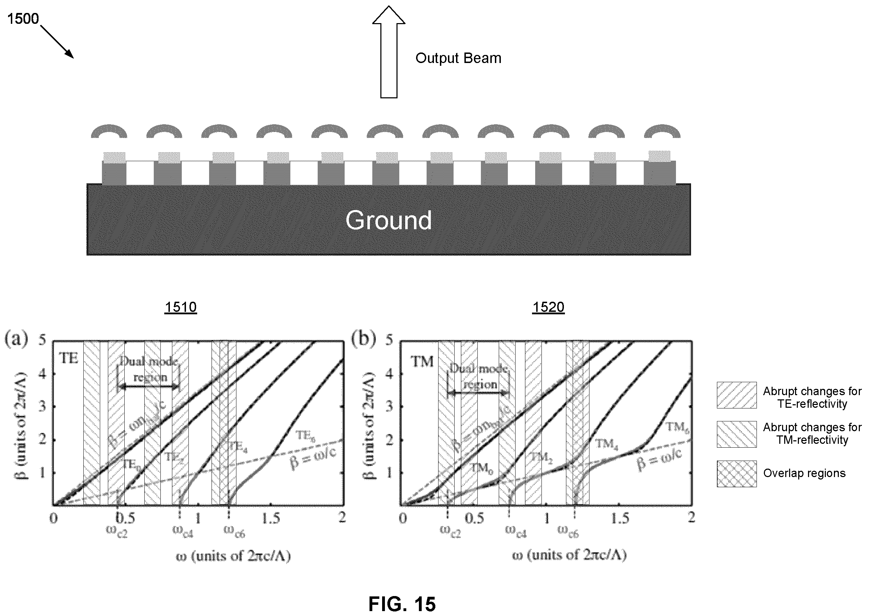

Fig. 15 illustrates use of an example vertical-cavity surface-emitting laser (VCSEL) based electro-absorption modulated laser (EML) incorporating high contrast grating (HCG) with Pockels material in polarization modulation, in accordance with the present disclosure. Referring to Fig. 15, there is shown VCSEL-EML 1500.

The VCSEL-EML 1500 may be substantially similar to the VCSEL-EML described with respect to Fig. 9. However, the VCSEL-EML 1500 may differ in that the contacts (e.g., metal contacts) are disposed on top of the Pockels material, as shown in Fig. 15. As illustrated in Fig. 15, the VCSEL-EML 1500 may function as polarization modulator. Nonetheless, polarization modulation as described herein is not limited the particular implementation corresponding to the VCSEL-EML 1500, and such polarization modulation may be applicable to and/or provided by any of the proposed EML based structures disclosed herein.

In this regard, the HCG may have strong birefringence between transverse electric (TE) and transverse magnetic (TM) modes. As such, the design and/or implementation of the device may be adapted to utilize such characteristics in providing polarization modulation via the proposed EML based structures (incorporating Pockels material). This may be doable for any of the implementations disclosed herein. The polarization modulation may be provided by taking advantage of, e.g., the interdigitated contact arrangements in the proposed EML structures. As such, the same principles and approach used in wavefront modulation may be used for polarization modulation-e.g., by connecting all the teeth of HCG to the same bias source. The polarization modulation may be viewed as a subset of amplitude modulation schemes.

For example, polarization modulation may be achieved by applying modulation to allow or suppress modes inside the HCG. In this regard, HCG properties may change specularly in the vicinity of mode cutoff(s), as illustrated in graphs 1510 and 1520, which show abrupt changes for TE-reflectivity and abrupt changes for TM-reflectivity, as well as regions of overlapping. In this regard, at overlapping transitions frequencies (e.g., for TM6/TE6), there may be a strong sensitivity of both polarization to refractive index changes. The EML structure may be modified to optimize polarization modulation. For example, the appropriate thickness of HCG may allow for identifying spot(s) where TE reflectivity increases as TM reflectivity decreases (or vice versa) when changing bias.

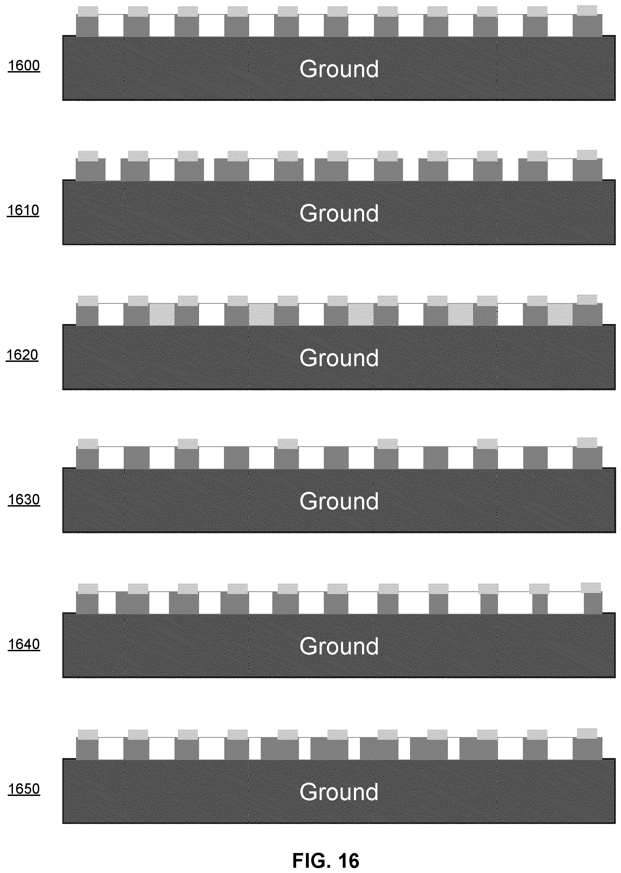

Fig. 16 illustrates example variations of high contrast grating (HCG) structures with Pockels material, in accordance with the present disclosure. Referring to Fig. 16, there are shown various variations of HCG with Pockels material. In particular, shown in Fig. 16 are HCGs 1600, 1610, 1620, 1630, 1640, and 1650. In this regard, HCG 1600 represent the base implementation, and HCGs 1610, 1620, 1630, 1640, and 1650 represent alternative variations of the base implementation.

Variations from the base implementation (HCG 1600) may comprise dimerized versions of HCG. In this regard, lower resonance frequency may be possible with such variations. Such variations may be of different flavors. For example, this may be done by changing the geometrical parameters, such as width of the high or low index material, as illustrated in HCG 1640 (variation 1), by changing material every second teeth, as illustrated in HCG 1640 (variation 2), or by connecting every $2^{nd}$ tooth, as illustrated in HCG 1640 (variation 3).

Patterns of the HCG also may be varied spatially-e.g., based on changes in the pattern in x- or y-directions. This may include a slow shift of the resonance with the space-e.g., less than 1% variation over lambda, as illustrated in HCG 1640 (variation 4), or an abrupt shift of HCG parameters-e.g., one or more parameter have 1% variation between one repetition of the motif and the next, but the geometry is stable over more than 10 lambda, as illustrated in HCG 1640 (variation 5).

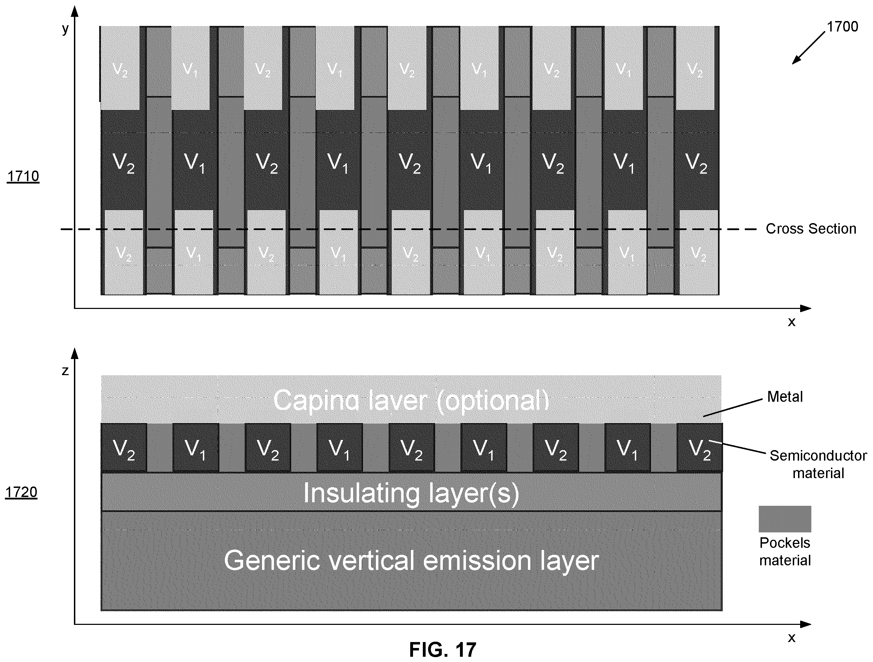

Fig. 17 illustrates a first example implementation of an interdigitated electro-absorption modulated laser (EML) based structure, in accordance with the present disclosure. Referring to Fig. 17, there is shown an EML based structure 1700. In particular, illustrated in Fig. 17 is a top view 1710 of the EML based structure 1700, as well as a side view 1720 corresponding to particular cross section (line) in the structure.

As illustrated in the side view 1720, the EML based structure 1700 comprises a generic vertical emitting layer followed (in the z-direction), that is, topped, by insulating layer(s), and then a high contrast grating (HCG) that comprises two contacts (V1 and V2) comprising semiconductor (e.g., doped semiconductor) material with metal on top, with Pockels material disposed in-between the contacts. The contacts are covered (optionally) by a capping layer (which is not shown in the top view 1710).

The generic vertical emitting layer may comprise any suitable structure that may be configured in emitting a laser vertically. In an example implementation, the generic vertical emitting layer may comprise a substrate, which may be optionally sandwiched between two vertical emitting epi-stack layers. In this regard, the epi-stack may comprise a VCSEL or PCSEL (or $2^{nd}$, $3^{rd}$, ... , $n^{th}$ order distributed-feedback laser (DFB)). The substrate may comprise suitable material, such as gallium arsenide (GaAs), gallium nitride (GaN), indium phosphide (InP), silicon (Si), silicon carbide (SiC), or the like.

The insulating layer may comprise semiconductor (doped or undoped current blocking layer), or ceramics (aluminum oxide $AlO_x$, silicon nitride (SiN), silicon oxide (SiO2), etc.). The Pockels material may comprise large r33 material.

The metal used in the contacts may comprise gold (Au), silver (Ag), copper (Cu), or transparent conducting materials (e.g., like indium tin oxide (ITO), or the like).

The Pockels material used in this implementation may need to have low refractive index (e.g., IR <2), such as a polymer. As illustrated in the top view 1710, in the example implementation shown in Fig. 17, there may be partial or complete coverage of doped semiconductor (of the contacts) in the y-direction. The balance between optical losses and RF electrical losses depends on exact application. As noted, the vertical emitting epi stack layer(s) may or may not be included, either between substrate and the EML, or below the substrate.

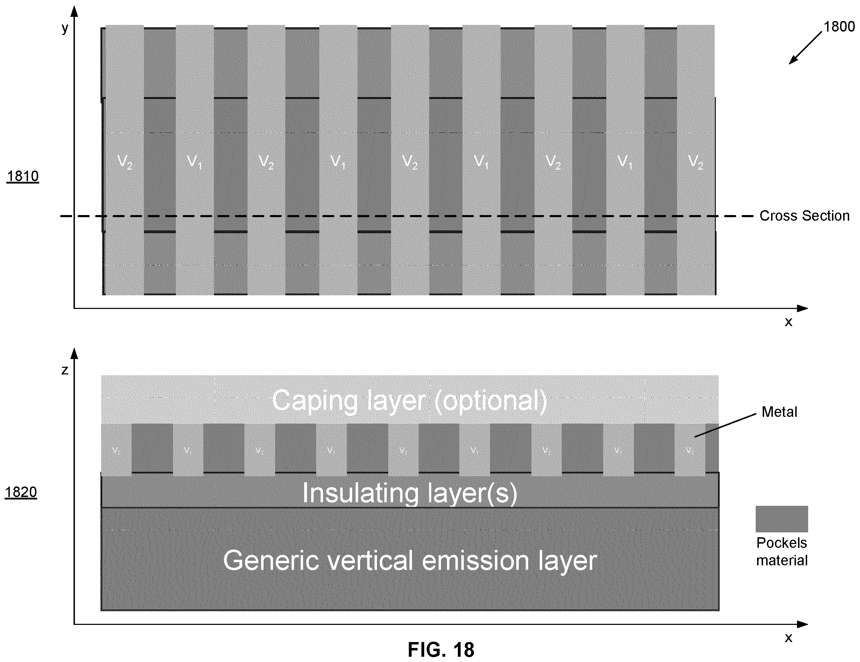

Fig. 18 illustrates a second example implementation of an interdigitated electro-absorption modulated laser (EML) based structure, in accordance with the present disclosure. Referring to Fig. 18, there is shown an EML based structure 1800. In particular, illustrated in Fig. 18 is a top view 1810 of the EML based structure 1800, as well as a side view 1820 corresponding to particular cross section (line) in the structure.

As illustrated in the side view 1820, the EML based structure 1800 comprises generic vertical emitting layer followed (in the z-direction), that is, topped, by insulating layer(s), and then a high contrast grating (HCG) that comprises two contacts (V1 and V2) with Pockels material disposed in-between the contacts. The contacts are covered (optionally) by a capping layer (which is not shown in the top view 1810).

The generic vertical emitting layer may comprise any suitable structure that may be configured to enable emitting a laser vertically. In an example implementation, the generic vertical emitting layer may comprise a substrate, which may be optionally sandwiched between two vertical emitting epi-stack layers. The epi-stack may comprise a VCSEL or PCSEL (or 2nd, 3rd, ... , nth order Distributed-feedback laser (DFB)). The substrate may comprise suitable material, such as gallium arsenide (GaAs), gallium nitride (GaN), indium phosphide (InP), silicon (Si), silicon carbide (SiC), or the like.

The insulating layer may comprise semiconductor (doped or undoped current blocking layer), or ceramics (aluminum oxide $AlO_x$, silicon nitride (SiN), silicon oxide ($SiO_2$), etc.).

The Pockels material may comprise large r33 material. In implementation 1800, the contacts (V1 and V2) may comprise transparent metal with low index n<1.6 (e.g., silver nanowire (AgNW), CN, hybrids, or the like).

The Pockels material used in this implementation may need to have high refractive index >2 (e.g., SBN60, BaTi03, etc.). Further, as with the prior implementations, the vertical emitting epi stack layer(s) may or may not be included, disposed either between substrate and the EML, or below the substrate.

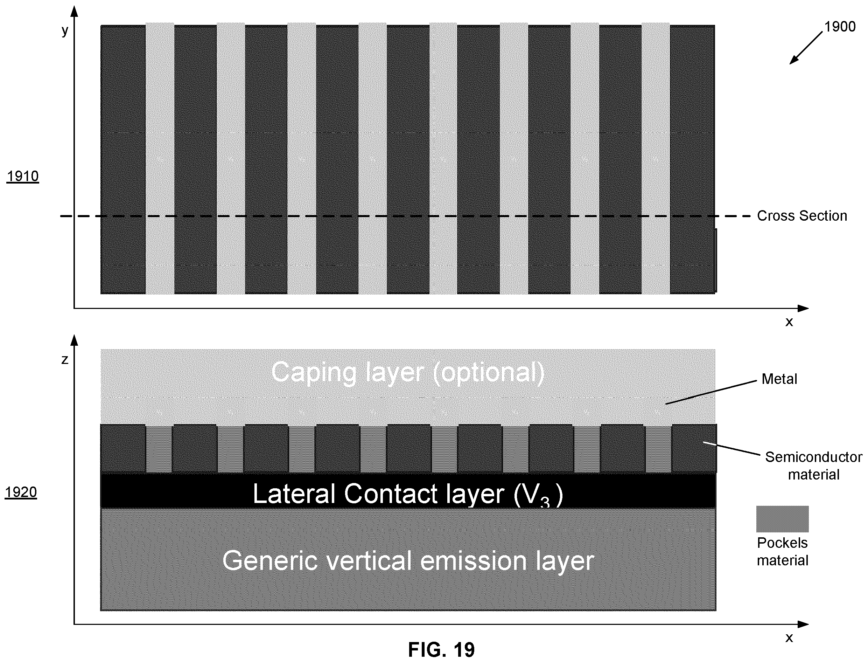

Fig. 19 illustrates a third example implementation of an interdigitated electro-absorption modulated laser (EML) based structure, in accordance with the present disclosure. Referring to Fig. 19, there is shown an EML based structure 1900. In particular, illustrated in Fig. 19 is a top view 1910 of the EML based structure 1900, as well as a side view 1920 corresponding to particular cross section (line) in the structure.

As illustrated in the side view 1920, the EML based structure 1900 comprises generic vertical emitting layer followed (in the z-direction)-that is, topped-by a lateral contact layer, and then a high contrast grating (HCG) that comprises two contacts (V1 and V2) comprising semiconductor (e.g., doped semiconductor) material with metal on top, with Pockels material disposed in-between the contacts metal on top of Pockels material, with undoped semiconductor material disposed in-between the contacts-particularly the Pockels material thereof, as shown. The contacts are covered (optionally) by a capping layer (which is not shown in the top view 1910).

The generic vertical emitting layer may comprise any suitable structure that may be configured to enable emitting a laser vertically. In an example implementation, the generic vertical emitting layer may comprise a substrate, which may be optionally sandwiched between two vertical emitting epi-stack layers. The epi-stack may comprise a VCSEL or PCSEL (or 2nd, 3rd, ... , nth order Distributed-feedback laser (DFB)). The substrate may comprise suitable material, such as gallium arsenide (GaAs), gallium nitride (GaN), indium phosphide (InP), silicon (Si), silicon carbide (SiC), or the like.

The lateral contact layer may comprise transparent and electrically conductive material. The Pockels material may comprise large r42, 63, etc., Pockels material. The metal of the contacts may comprise gold (Au), silver (Ag), copper (Cu), or transparent conducting materials (e.g., like indium tin oxide (ITO), or the like).

The Pockels material used in this implementation may need to have low refractive index (e.g., IR <2), such as KDP, polymer, etc. In some instances, in this implementation, bias may be applied to the lateral contact layer, resulting in 3 different biases applied. Nonetheless, in many instances, the bias applied to lateral contact layer may be the same as a bias applied to one of the contacts (e.g., $V_3 = V_2 = 0$). Further, as with the prior implementations, the vertical emitting epi stack layer(s) may or may not be included, either between a substrate and the EML, or below the substrate.

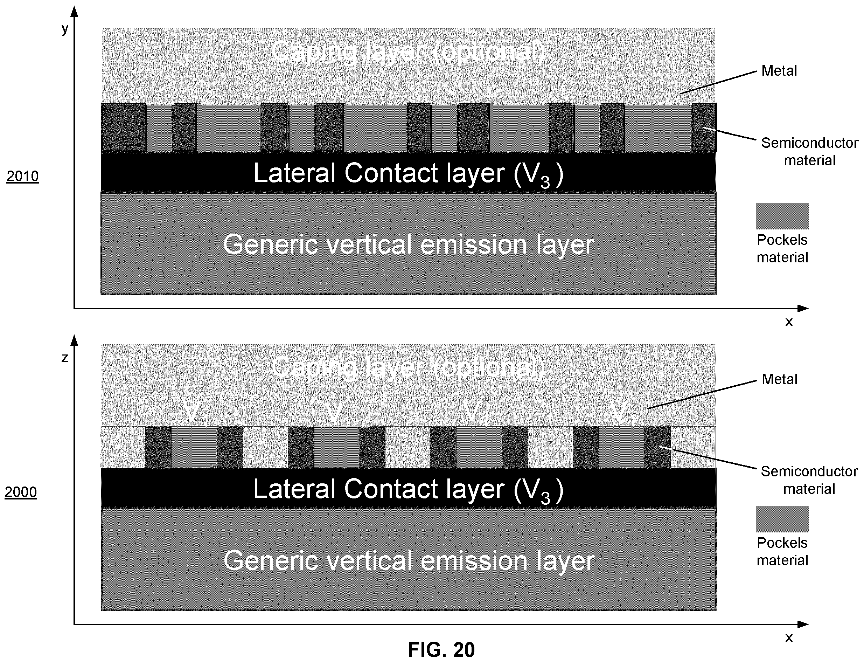

Fig. 20 illustrates fourth and fifth example implementations of an interdigitated electro-absorption modulated laser (EML) based structure, in accordance with the present disclosure. Referring to Fig. 20, there are shown EML based structures 2000 and 2010 (each as viewed from the side).

As shown in Fig. 20, each of the EML based structures 2000 and 2010 comprises generic vertical emitting layer followed (in the z-direction), that is, topped, by a lateral contact layer, and then a high contrast grating (HCG) that comprises two contacts (V1 and V2) comprising semiconductor (e.g., doped semiconductor) material with metal on top, with contact metal on top of the Pockels material, with undoped semiconductor material disposed in-between the contacts-particularly the Pockels material thereof, as shown. The contacts are covered (optionally) by a capping layer (which is not shown in the top view 2010).

The generic vertical emitting layer may comprise any suitable structure that may be configured to enable emitting a laser vertically. In an example implementation, the generic vertical emitting layer may comprise a substrate, which may comprise emitting epi-stack layers on either surface of the substrate. The epi-stack may comprise a VCSEL or PCSEL (or 2nd, 3rd, ... , nth order Distributed-feedback laser (DFB)). The substrate may comprise suitable material, such as gallium arsenide (GaAs), gallium nitride (GaN), indium phosphide (InP), silicon (Si), silicon carbide (SiC), or the like.

The lateral contact layer may comprise transparent and electrically conductive material. The Pockels material may comprise large r42, 63, etc., Pockels material. The metal of the contacts may comprise gold (Au), silver (Ag), copper (Cu), or transparent conducting materials (e.g., like indium tin oxide (ITO), or the like).

The EML based structures 2000 and 2010 may be substantially similar to the EML based structure 1900 as described with respect to Fig. 19. However, the EML based structures 2000 and 2010 differ from one another (and from the EML based structure 1900) in that there are some variations in the HCG in each of these structures. In particular, the HCG of the EML based structure 2000 differs from the HCG of the EML based structure 2000 in that the contacts (V1 and V2) are of different size in the EML based structure 2000 (e.g., V1 is larger in V2, as shown in Fig. 20), whereas these contacts are the same size in the EML based structure 1900.

As for the EML based structure 2010, the HCG used therein differs in that it incorporates capping layer material (in addition to the undoped semiconductor material) in-between the contacts, as shown in Fig. 20. Further, the EML based structures 2000 and 2010 differ from the EML based structure 1900 in that the biases are different (e.g., $V_1 = V_2 \neq V_3$). However, these two Implementations may exhibit similar physical effects as interdigitated EML based implementations because an effective refractive index varies differently in each dimer. In this regard, a similar effect may be obtained by, e.g., filling only about ½ of the HCG groves with Pockels materials, as shown in Fig. 20.

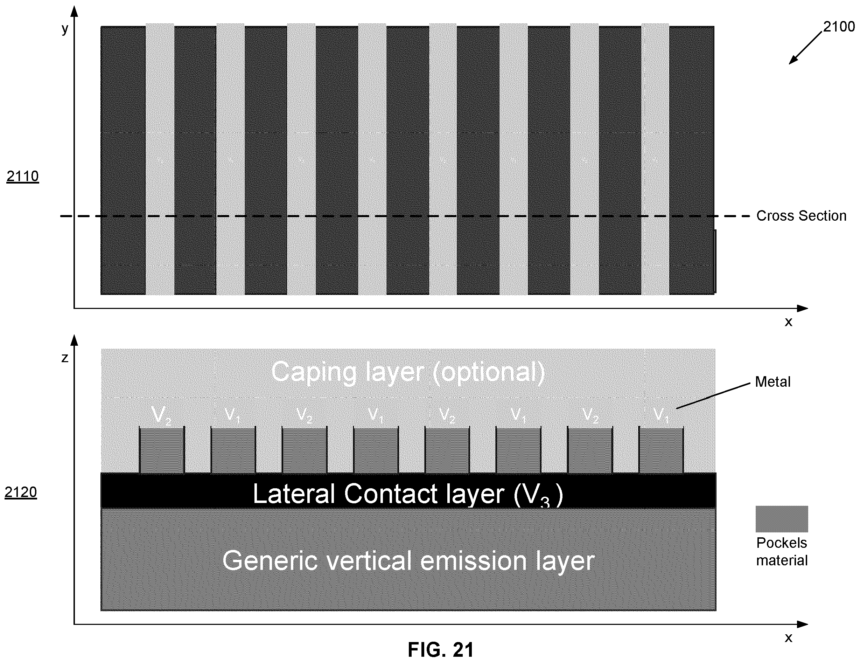

Fig. 21 illustrates a sixth example implementation of an interdigitated electro-absorption modulated laser (EML) based structure, in accordance with the present disclosure.

Referring to Fig. 21, there is shown an EML based structure 2100. In particular, illustrated in Fig. 21 is a top view 2110 of the EML based structure 2100, as well as a side view 2120 corresponding to particular cross section (line) in the structure.

As illustrated in the side view 2120, the EML based structure 2100 comprises generic vertical emitting layer followed (in the z-direction), that is, topped, by a lateral contact layer, and then a high contrast grating (HCG) that comprises two contacts (V1 and V2) comprising semiconductor (e.g., doped semiconductor) material, with metal on top of the Pockels material. The contacts are covered (optionally) by a capping layer (which is not shown in the top view 2110). The capping material is also disposed in-between the contacts-particularly in-between the Pockels material thereof, as shown.

The generic vertical emitting layer may comprise any suitable structure that may be configured to enable emitting a laser vertically. In an example implementation, the generic vertical emitting layer may comprise a substrate, which may comprise emitting epi-stack layers on either surface. The epi-stack may comprise a VCSEL or PCSEL (or 2nd, 3rd, ... , nth order Distributed-feedback laser (DFB)). The substrate may comprise suitable material, such as gallium arsenide (GaAs), gallium nitride (GaN), indium phosphide (InP), silicon (Si), silicon carbide (SiC), or the like.

The lateral contact layer may comprise transparent and electrically conductive material. The Pockels material may comprise large r42, 63, etc., Pockels material. The metal of the contacts may comprise gold (Au), silver (Ag), copper (Cu), or transparent conducting materials (e.g., like indium tin oxide (ITO), or the like).

Similar to the EML based structure 1900, the Pockels material used in this implementation may need to have low refractive index (e.g., IR <2), such as KDP, polymer, etc., and, in some instances, bias may be applied to the lateral contact layer, resulting in 3 different biases applied (but, in many instances, the bias applied to the lateral contact layer may be the same as a bias applied to one of the contacts (e.g., $V_3 = V_2 = 0$)). Further, as with the prior implementations, the vertical emitting epi stack layer(s) may or may not be included, either between substrate and the EML, or below the substrate. While not shown, as with the EML based structure 1900, alternate implementations may be used by modifying the HCG structure in the same manner the HCG is modified in the EML based structures 2000 and 2010 relative to the EML based structure 1900, as described with respect to Fig. 20.

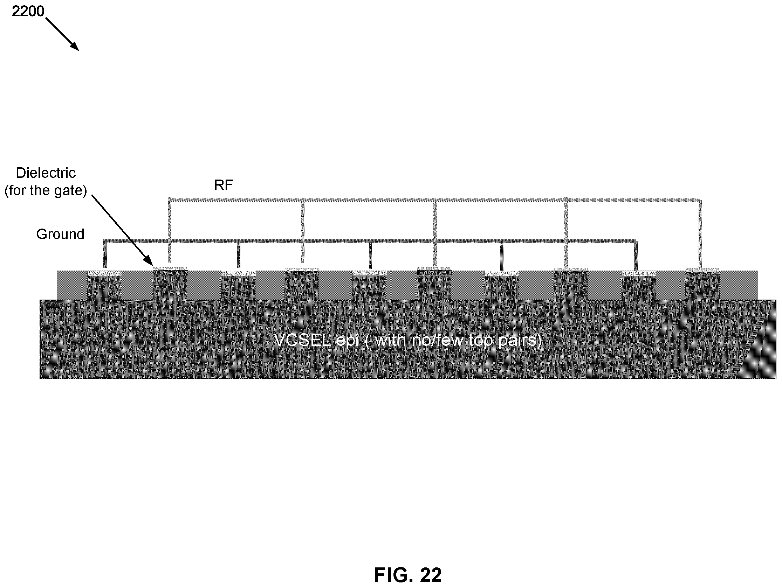

Fig. 22 illustrates an example vertical-cavity surface-emitting laser (VCSEL) based electro-absorption modulated laser (EML) incorporating high contrast grating (HCG) with Pockels material and with a dielectric for gates, in accordance with the present disclosure. Referring to Fig. 22, there is shown VCSEL 2200.

The VCSEL 2200 may comprise a VCSEL epi layer (with no or few top pairs), with grating (e.g., HCG) structure on top having Pockels material filling the gaps within the grating structure, and with contacts on the top of the surface of the grating structure. Some of the contacts may incorporate dielectric (for the gate). As such some of the contacts (e.g., those lacking dielectric) may form and/or operate as ground whereas the remaining contact (e.g., those incorporating dielectric) may as the RF element in the VCSEL 2200.

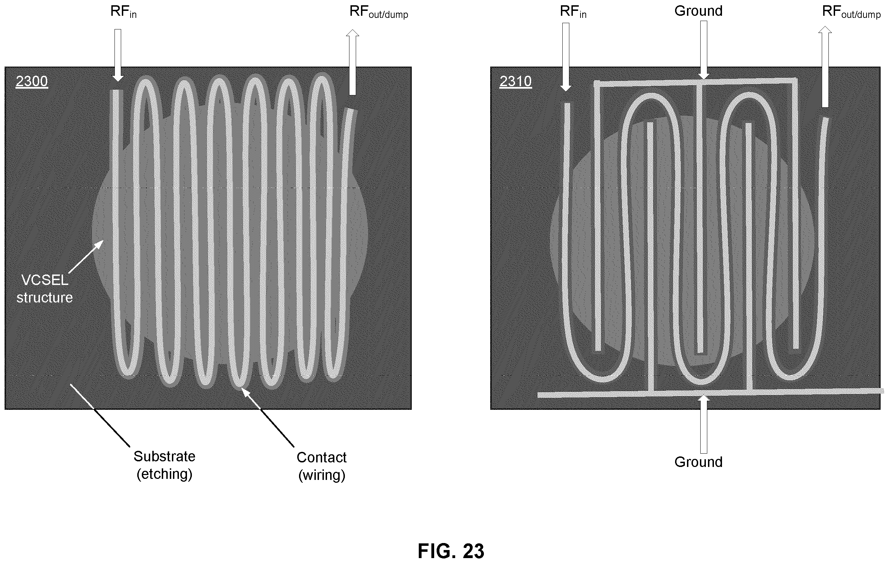

Fig. 23 illustrates example vertical-cavity surface-emitting laser (VCSEL) based optical devices with one incorporating electro-absorption modulated laser (EML) based design. Shown in Fig. 23 are optical devices 2300 and 2310, both of which are a VCSEL based device. In this regard, top view(s) of the optical devices 2300 and 2310 are shown in Fig. 23.

As illustrated in Fig. 23, the optical device 2300 comprises a VCSEL based structure (e.g., as described with respect to Fig. 2) on top of a substrate etching, with contact (wiring) on top of the VCSEL structure. The optical device 2300 may be configured to emit light (e.g., laser) in response to applying of $RF_{in}$ signal as input into contact wiring on one end, and outputting of a corresponding $RF_{out/dump}$ signal as output at the other end of the contact wiring.

The optical device 2310 represents an example modification of the optical device 2300 in accordance with an example implementation based on the present disclosure. In this regard, the optical device 2310 may be substantially similar to the optical device 2300, but may incorporate modification(s) to allow for providing the modulation functions and/or characteristics thereof as described herein. For example, the optical device 2310 may incorporate modifications of the contact wirings, such as by use of multiple separate contact wirings, as illustrated in Fig. 23, to form an interdigitated grating based design that allows for biasing of the contacts, as described above, such as by grounding (e.g., applying ground signal(s) into) some of the contact wirings as shown in Fig. 23.

As utilized herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z." As utilized herein, the term "exemplary" means serving as a non-limiting example, instance, or illustration. As utilized herein, the terms "for example" and "e.g." set off lists of one or more non-limiting examples, instances, or illustrations.

As utilized herein the terms "circuits" and "circuitry" refer to physical electronic components (e.g., hardware), and any software and/or firmware ("code") that may configure the hardware, be executed by the hardware, and or otherwise be associated with the hardware. As used herein, for example, a particular processor and memory (e.g., a volatile or non-volatile memory device, a general computer-readable medium, etc.) may comprise a first "circuit" when executing a first one or more lines of code and may comprise a second "circuit" when executing a second one or more lines of code. Additionally, a circuit may comprise analog and/or digital circuitry. Such circuitry may, for example, operate on analog and/or digital signals. It should be understood that a circuit may be in a single device or chip, on a single motherboard, in a single chassis, in a plurality of enclosures at a single geographical location, in a plurality of enclosures distributed over a plurality of geographical locations, etc. Similarly, the term "module" may, for example, refer to a physical electronic component (e.g., hardware) and any software and/or firmware ("code") that may configure the hardware, be executed by the hardware, and or otherwise be associated with the hardware.

As utilized herein, circuitry or module is "operable" to perform a function whenever the circuitry or module comprises the necessary hardware and code (if any is necessary) to perform the function, regardless of whether performance of the function is disabled or not enabled (e.g., by a user-configurable setting, factory trim, etc.).

Other embodiments of the invention may provide a non-transitory computer readable medium and/or storage medium, and/or a non-transitory machine readable medium and/or storage medium, having stored thereon, a machine code and/or a computer program having at least one code section executable by a machine and/or a computer, thereby causing the machine and/or computer to perform the processes as described herein.

Various embodiments in accordance with the present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

**Claims**

1. An optical device comprising:

   an optical source; and
   an electro-absorption modulated laser (EML) based structure on top of the optical source,
   wherein the EML based structure comprises a grating structure,
   wherein the grating structure comprises a plurality of grating lines, and
   wherein the grating structure further comprises Pockels material disposed within the grating structure.

2. The optical device according to claim 1, wherein at least a portion of the Pockels material is disposed within the plurality of grating lines.

3. The optical device according to claim 1, wherein at least a portion of the Pockels material is disposed in spaces between the plurality of grating lines.

4. The optical device according to claim 1, wherein at least one grating line of the plurality of grating lines comprises bottom part comprising Pockels material with a contact on top of the bottom part.

5. The optical device according to claim 1, further comprising a substrate bearing both of the electro-absorption modulated laser (EML) based structure and the optical source.

6. The optical device according to claim 1, wherein the grating structure comprises a high contrast grating (HCG) based structure.

7. The optical device according to claim 1, wherein the optical source comprises a vertical-cavity surface-emitting laser (VCSEL) based structure.

8. The optical device according to claim 7, wherein the vertical-cavity surface-emitting laser (VCSEL) based structure comprises at least a top mirror layer, a bottom mirror layer, and a quantum wells layer disposed between the top mirror layer, a bottom mirror layer.

9. The optical device according to claim 1, wherein the optical source comprises a photonic-crystal surface-emitting laser (PCSEL) based structure.

10. The optical device according to claim 1, wherein the optical source comprises a high-order distributed feedback polymer (DFB) based structure.

11. The optical device according to claim 1, wherein the electro-absorption modulated laser (EML) based structure is configured to provide amplitude modulation to incident beams or waves applied onto the EML based structure.

12. The optical device according to claim 11, wherein the grating structure comprises one or more grating features or characteristics configured to, when providing the amplitude modulation, adjust or modifying intensity or power of output beams or waves corresponding to the incident beams or waves.

13. The optical device according to claim 1, wherein the electro-absorption modulated laser (EML) based structure is configured to provide wavefront modulation to incident beams or waves applied onto the EML based structure.

14. The optical device according to claim 13, wherein the electro-absorption modulated laser (EML) based structure is configured to provide the wavefront modulation based on an adjustment to a refractive index (RI) associated with the electro-absorption modulated laser (EML) based structure.

15. The optical device according to claim 14, wherein the electro-absorption modulated laser (EML) based structure is configured to enable adjusting the refractive index (RI) based on biasing or changing of electric field applied across the Pockels material.

16. The optical device according to claim 13, wherein the grating structure is configured to, when providing the wavefront modulation, deflect the incident beams or waves to one or more discrete angles.

17. The optical device according to claim 1, wherein the electro-absorption modulated laser (EML) based structure is configured to provide polarization modulation to incident beams or waves applied onto the EML based structure.

18. The optical device according to claim 17, wherein the grating structure is configured to, when providing the polarization modulation, apply polarization rotation to output beams or waves corresponding to the incident beams or waves.

19. The optical device according to claim 17, wherein the grating structure comprises one or more grating features configured for use in providing the polarization modulation, and wherein the one or more grating features are inherently linear polarizers.

20. The optical device according to claim 19, wherein the one or more grating features are configured to selectively transmit optical beams having polarizations in a particular direction.

100

Pockels material

contact

monolithic HCG

active

cavity

DBR

Substrate

Heat sink

$L$

$h_N$

$h$

$a$

FIG. 1A

FIG. 1B

200

FIG. 2

300

Photonic Crystal

MQW

DBR Mirror

$I_{ac} + I_{dc}$

FIG. 3

400

High order grating

MQW

DBR Mirror

$I_{ac} + I_{dc}$

FIG. 4

FIG. 5A

FIG. 5B

540

$V_{ac}$

EML

Electrical insulating layer

$I_{dc}$

Generic Vertical Emitting laser

FIG. 5C

FIG. 6

700

2a = 480 nm

250 nm

p-Si   p-Si

i-Si   i-Si

n-Si   n-Si   n-Si   50 nm

156 nm   183 nm   3 μm

SiO₂

Si substrate

720

710

**FIG. 7**

FIG. 8

FIG. 9

FIG. 10

**FIG. 11**

FIG. 12

1300

Incident Beam ↓ Output Beam ↑ Output Beam

Ground

V1= V2 → In phase

Incident Beam ↑

Incident Beam

Incident Beam ↓ Output Beam ↗

$n + \delta n$  E  $n$

Ground

V1≠ V2 (=0) → Out of phase

Incident Beam ↑

FIG. 13

**FIG. 14**

FIG. 15

FIG. 16

FIG. 17

FIG. 18

FIG. 19

FIG. 20

2100

2110

Cross Section

y

x

2120

z

Caping layer (optional)

Metal

$V_2$  $V_1$  $V_2$  $V_1$  $V_2$  $V_1$  $V_2$  $V_1$

Lateral Contact layer ($V_3$)

Generic vertical emission layer

Pockels
material

x

**FIG. 21**

FIG. 22

FIG. 23

**REFERENCES CITED IN THE DESCRIPTION**

**Patent documents cited in the description**

- US 63532778

- US 63575281